# EUROPEAN PATENT APPLICATION

(11) **EP 3 683 939 A1**
(43) Date of publication of application: **22.07.2020**
(21) Application number: 19275006.5
(22) Date of filing: 15.01.2019
(51) Int. Cl.: H02K 11/21, H02K 11/215, H02K 11/225, H02K 1/17

(54) **SENSING AND HEALTH MONITORING OF FLUX-SWITCHING MOTOR**

(71) Applicant: Hamilton Sundstrand Corporation, Charlotte, NC 28217 (US)
(72) Inventor: SAWATA, Tadashi, Coventry, CV3 5BN (GB); SANGHA, Parminder, Solihull, West Midlands B93 8SY (GB)
(74) Representative: Dehns

(57) **Abstract**

The present disclosure makes use of what is typically considered a problem with doubly salient permanent magnet machines - i.e. the external flux leakage - in that a sensor external to the stator core measures flux leakage and uses this as an indication of rotor position and/or the health of the machine.

## Description

### TECHNICAL FIELD

The present disclosure relates to monitoring the position of a rotor and/or monitoring motor health.

### BACKGROUND

Motors for converting electric power into torque are used in a very wide range of applications. Motors generally comprise a stator and a rotor that rotates relative to the stator with magnets located in the rotor. Magnetic fields generated by the rotor and stator interact with each other, which converts electric power to mechanical power.

A standard permanent magnet motor has a stator having teeth around which are wound electrical coils and permanent magnets are located on or within the rotor. Magnetic flux is maintained within the stator core.

Doubly salient permanent magnet machines in which permanent magnets are located in the stator, can be superior over conventional permanent magnet machines in terms of power density and robustness, which are essential characteristics for electric propulsion and other aerospace applications. A flux switching machine is an example of a doubly salient permanent magnet machine that can be used in aircraft.

A problem with such machines is that they can have leakage flux outside the stator core and housing.

To monitor and control operation of the motor to provide the required power, it is necessary to monitor the position of the rotor, from which the rotor speed can be determined and also the appropriate windings can be excited. There are various known ways of measuring rotor position, such as encoders or resolvers or Hall-effect sensors installed inside the motor. US 9,722,517 teaches a flux monitor for determining rotor position.

Typically, devices for sensing rotor position include rotating components mounted inside the motor. This requires space inside the motor and also increases the weight of the motor and the difficulty of maintenance of the components.

In e.g. aircraft, the machines or motors that provide electric propulsion need to be efficient and have a high power density. It is, therefore, undesirable to use up space within these motors for rotor position sensing equipment particularly since sensors for such motors have to be very robust and will, therefore, typically be larger and heavier than might be needed for motors in other fields. Rotating components will have a limited life due to wear and therefore also have limited reliability.

There is a need for high power density electric machines with robust sensing mechanisms for reliably determining rotor position and monitoring machine health.

### SUMMARY

The present disclosure makes use of what is typically considered a problem with doubly salient permanent magnet machines - i.e. the external flux leakage - in that a sensor external to the stator core measures flux leakage and uses this as an indication of rotor position and/or the health of the machine.

The present disclosure thus provides a permanent magnet machine assembly comprising a motor formed of a stator having a plurality of permanent magnets mounted thereon or integrated therein and a rotor rotatable relative to the stator to generate electric power, whereby the assembly further comprises means mounted external to the stator for measuring flux leakage external to the motor and means for deriving rotor position from the measure of flux leakage.

The disclosure also provides a method of determining the position of a rotor in a permanent magnet machine comprising a stator having a plurality of permanent magnets mounted thereon or integrated therein and a rotor rotatable relative to the stator to generate electric power, the method comprising measuring leakage flux external to the stator and deriving rotor position from the measured leakage flux. Various sensors can be used to measure the flux leakage, and these can take various positions, e.g., in the motor housing between the stator and the motor housing, external to the housing.

### BRIEF DESCRIPTION OF THE DRAWINGS

Preferred embodiments will now be described by way of example only and with reference to the drawings.
- Fig. 1: shows a conventional permanent magnet machine and its flux plot.
- Fig. 2: shows the flux plot of a doubly-salient permanent magnet machine.
- Fig. 3: shows an example of an assembly according to the disclosure.
- Fig. 4: shows an example of voltage sensed external to the stator core.

### DETAILED DESCRIPTION

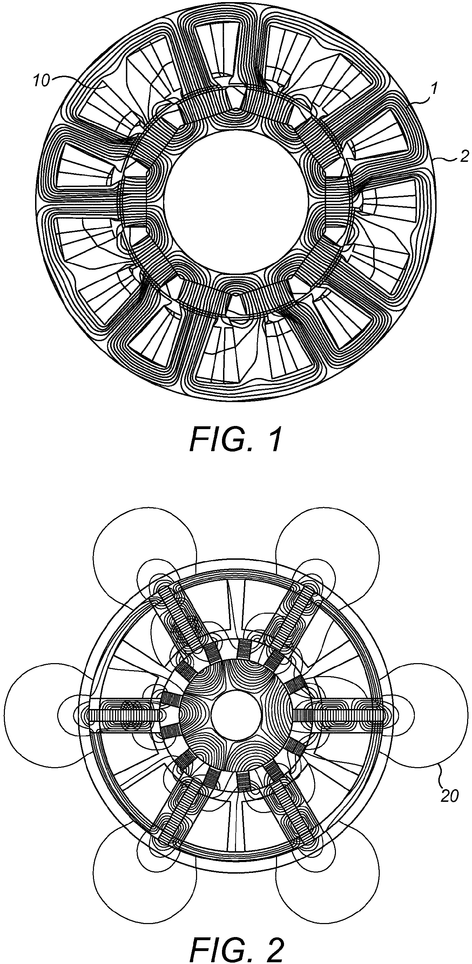

Fig. 1 shows how, in a conventional permanent magnet machine, the flux lines 10 are all contained within the stator core 1 and housing 2. Such machines and their behaviour are well-known and need no further explanation here.

Fig. 2 shows how, in contrast, for doubly-salient permanent magnet machines where the magnets are in or on the stator, the flux lines 20 extend out of the housing due to flux leakage. The amount of flux leakage has been found to be a function of the rotor position.

The inventors have therefore used this 'problem' to their advantage - i.e. to allow the rotor position to be determined by means of an external sensor that measures the leakage flux.

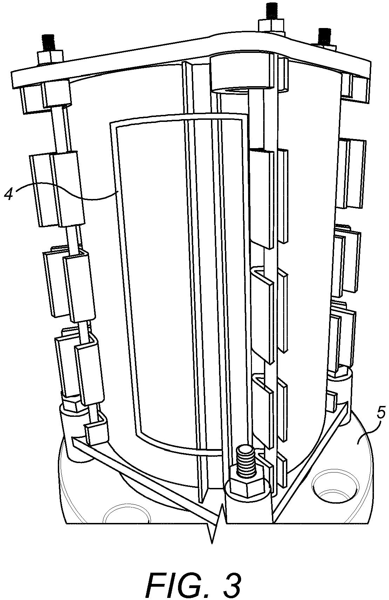

Any known, or yet to be developed, means for measuring flux can be used such as, but not limited to, Hall-effect sensors, search coils, magneto-optical sensors etc. Fig. 3 shows an example of a search coil 4 mounted outside the motor housing 5. The sensing device could also be mounted or integrated in the motor housing or located on its inner surface outside of the stator core.

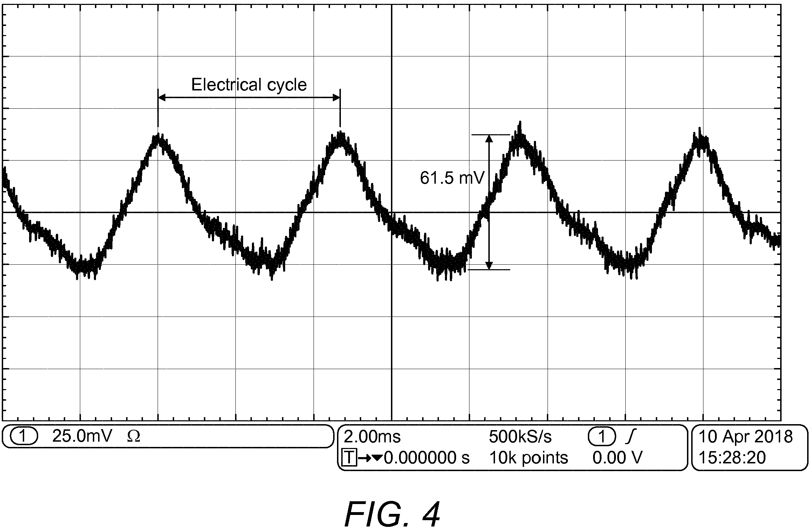

The voltage sensed outside the stator core will have a general pattern as shown in Fig. 4 where the period of the voltage corresponds to electrical cycle, and electrical position can be deduced from the amplitude and slope of the voltage. Speed of the rotor can be deduced from the frequency of the measured voltage. The health of the machine can be determined by analysing the shape and amplitude of the voltage corresponding to the leakage flux.

One example of a sensor for detecting leakage flux outside of the motor is a Hall-effect sensor. Hall-effect sensors are known in the art. According to the disclosure, such a sensor could be located on the outer surface of the motor housing, or in the housing between the stator core and the housing to measure the flux that leaks outside of the stator core. In one example, multiple Hall-effect sensors could be placed above different magnet poles with phase shifts to increase accuracy and resolution.

An alternative sensor for the leakage flux might be a search coil, an example of which is shown in Fig. 3. Again, this could be positioned on the outer surface of the motor housing, or in the housing between the stator core and the housing to measure the flux that leaks outside of the stator core. As with Hall-effect sensors, multiple sensor coils could be placed above different magnet poles. An advantage of using a search coil is that no power supply or excitation is required.

Another possibility is a magneto-optical sensor or other magnetic sensor.

The sensed flux can then be converted, using a low-pass filter, an algorithm, look up table or the like relating rotor position to flux amplitude/frequency, to provide an indication of rotor position. This can be fed back to the motor control and/or analysed to monitor motor health.

The sensing assembly of this disclosure is particularly useful with the types of permanent magnet machines (doubly-salient/flux-switching machines) that can provide greater power density and robustness than conventional machines and so particular use in aerospace, electrical propulsion and other high performance applications. It can be used with any machine that has flux leakage outside the housing. The sensor located outside the stator which measures leakage flux to determine rotor position does not require rotating components and this allows for improved reliability and robustness. Such a sensor also does not require space within the stator core and so the motor power density is not compromised.

The sensor arrangement is simple and does not require excessive computing power and complex algorithms and processing, it also does not rely on operating parameters of the motor.

Because various sensors can be used, the designer has a choice according to the targeted application.

## Claims

1. A permanent magnet machine assembly comprising:
a motor formed of a stator having a plurality of permanent magnets mounted thereon or integrated therein; and
a rotor rotatable relative to the stator to generate electric power,
whereby the assembly further comprises means mounted external to the stator for measuring flux leakage external to the motor and means for deriving rotor position from the measure of flux leakage.

2. The assembly of claim 1, wherein the means for measuring flux leakage comprises a Hall-effect sensor.

3. The assembly of claim 1, wherein the means for measuring flux leakage comprises a sensor coil.

4. The assembly of claim 1, wherein the means for measuring flux leakage comprises a magnetic sensor.

5. The assembly of claim 1, wherein the means for measuring the flux leakage comprises a magneto-optical sensor.

6. The assembly of any preceding claim, wherein the stator is mounted for measuring within a motor housing, and wherein the means for measuring flux leakage is located between the housing and the stator.

7. The assembly of any preceding claim, wherein the stator is mounted for measuring within a motor housing, and wherein the means for measuring flux leakage is external to the housing.

8. The assembly of any preceding claim, wherein the stator is mounted for measuring within a motor housing, and wherein the means for measuring flux leakage is incorporated into the housing.

9. A method of determining the position of a rotor in a permanent magnet machine comprising:
a stator having a plurality of permanent magnets mounted thereon or integrated therein; and
a rotor rotatable relative to the stator to generate electric power,
the method comprising measuring leakage flux external to the stator and deriving rotor position from the measured leakage flux.
